# EUROPÄISCHE PATENTSCHRIFT

(11) **EP 1 802 786 B1**
(45) Veröffentlichungstag und Bekanntmachung des Hinweises auf die Patenterteilung: **09.07.2008**
(21) Anmeldenummer: 05768332.8
(22) Anmeldetag: 28.07.2005
(51) Int. Cl.: C23C 14/56, C23C 14/54

(54) **VORRICHTUNG UND VERFAHREN ZUM KÜHLEN BANDFÖRMIGER SUBSTRATE**
DEVICE AND METHOD FOR COOLING STRIP SUBSTRATES
DISPOSITIF ET PROCEDE POUR REFROIDIR DES SUBSTRATS EN BANDE

(30) Priorität: 19.10.2004 DE 102004050821
(43) Veröffentlichungstag der Anmeldung: 04.07.2007
(73) Patentinhaber: Fraunhofer-Gesellschaft zur Förderung der angewandten Forschung e.V., 80686 München (DE)
(72) Erfinder: METZNER, Christoph, 01328 Dresden (DE); HEINSS, Jens-Peter, 01309 Dresden (DE); KÜHN, Gerhard, 01097 Dresden (DE); WEISKE, Dieter, 01239 Dresden (DE)
(86) Internationale Anmeldenummer: PCT/EP2005/008162
(87) Internationale Veröffentlichungsnummer: WO 2006/042575

(56) Entgegenhaltungen:
- EP-A- 0 311 302
- WO-A-02/070778

## Beschreibung

Die Erfindung betrifft eine Vorrichtung und ein Verfahren zum Kühlen bandförmiger Substrate im Vakuum. Vorrichtung und Verfahren können in Vakuumanlagen überall dort zum Einsatz kommen, wo bandförmige Substrate einer thermischen Belastung ausgesetzt sind.

Beispiele hierfür sind verschiedene Formen der Vakuumbeschichtung, Oberflächenmodifizierungen oder Formen einer gezielten thermischen Behandlung von Oberflächen im Vakuum.

Eine Kühlung zu behandelnder Substrate ist technologisch bedingt häufig erforderlich, wenn ohne Kühlung durch thermische Belastung eine Schädigung des Substrates durch Überhitzung zu erwarten ist oder sich ohne Kühlung eine Substrattemperatur einstellen würde, die einem angestrebten Effekt entgegensteht. Beispiele für letzteres finden sich ebenfalls im Bereich der Vakuumbeschichtung. Häufig soll eine bestimmte Schicht auf einem Substrat abgeschieden werden, die besondere strukturelle Eigenschaften aufweist. Die Schichtstruktur zeigt oft eine starke Abhängigkeit von der Temperatur des Substrates.

Da Kühlen durch Konvektion im Vakuum bei geringen Drücken eine geringe Rolle spielt und effektives Abstrahlen erst bei Temperaturen erfolgt, die bei vielen Beschichtungsverfahren entweder gerade vermieden werden sollen oder durch andere technologische Randbedingungen nicht einstellbar sind, liegt der Schwerpunkt einer Substratkühlung bei Vakuumprozessen auf einer Ableitung der eingetragenen Energie durch Wärmeleitung vom Ort des Energieeintrags, also der Substratoberfläche, in und durch das Substrat hindurch zu einem Kühlkörper. Die Effektivität einer solchen Kühlung hängt im Wesentlichen davon ab, wie effektiv der Wärmeübergang vom Substrat auf den Kühlkörper erfolgen kann.

Es ist bekannt, bandförmige Substrate zu kühlen, indem sie über eine konvexe Kühlfläche, meist Teil der Mantelfläche einer weitgehend zylinderförmigen Kühlwalze, geführt werden. Die Effektivität der Kühlung wird dabei unter anderem über die Temperatur der Kühlwalze beeinflusst. Zu diesem Zweck werden Kühlmittel durch das Innere der Kühlwalze, auch Kühltrommel genannt, geführt (US 4,343,834; US 3,381,660; DE 1 741 856 U). Die Oberfläche der Kühlwalze wird also effektiv gekühlt, indem im Inneren der Kühlwalze eine Flüssigkeitskühlung vorgesehen ist. Dadurch erfolgt ein effektiver Wärmetransport von der Oberfläche der Kühlwalze in deren Inneres.

Die Kühlung der Walze beeinflusst die Temperatur des Substrates. Eine gekühlte Walze führt aber nur dann zu einer effektiven Kühlung des Substrates, wenn Kühlfläche und Substrat in einem innigen Wärmekontakt stehen.

Es ist bekannt, den Wärmekontakt zwischen Substrat und Kühlfläche durch Beilegen einer diesen Kontakt vermittelnden Folie zu verbessern (DE 37 40 483 A1; DE 28 45 131 A1), wobei auch bekannt ist, diese Folie vorzukühlen, wodurch die Wärmekapazität der Folie selbst zur Substratkühlung herangezogen wird. Ansonsten dient die Folie dabei in erster Linie einem Ausgleich von Unebenheiten der sich berührenden Flächen. Der Wärmetransfer durch Folien hindurch erfolgt jedoch insgesamt in für viele Anwendungen ungenügendem Umfang.

Es ist weiterhin bekannt, zum Kühlen bandförmiger Substrate deren Rückseite einer Kühlgasströmung auszusetzen, bevor das Substrat in Kontakt mit der Kühlfläche kommt (DE 198 53 418 A1; US 5,076,203; US 5,743,966). Die Zufuhr des Kühlgases erfolgt häufig in Form so genannter Gaslanzen. Dadurch soll im Kontaktbereich zwischen Kühlfläche und Substrat ein dünnes Gaspolster bestehen bleiben, das den Wärmekontakt vermitteln kann. Durch Zufuhr des Gases außerhalb des Kontaktbereiches zwischen Substrat und Kühlfläche strömt jedoch ein großer Teil des eingeleiteten Gases in den Prozessraum ab, steht somit nicht dem Gaspolster zwischen Substrat und Kühlfläche zur Verfügung, sondern belastet das Prozessvakuum.

Es ist bekannt, den Wärmekontakt über ein Gaspolster durch elektrische Felder und Plasmen zu intensivieren (GB 2 326 647 A). Die Wirkung derartiger Verfahren ist jedoch gering und lässt sich nur bei ausgewählten Substraten, wie beispielsweise Kunststofffolie realisieren.

Es ist bekannt, den Rezipienten aus mehreren Bereichen aufzubauen, die vakuumtechnisch teilweise entkoppelt sind (EP 0 311 302 A1). Der Gaseinlass erfolgt dabei außerhalb des Prozessraumes. Eine vollständige Entkopplung lässt sich jedoch auch auf diese Weise nicht oder nur mit großem technischen Aufwand erzielen.

Es ist bekannt, durch Erhöhen des Anpressdruckes zwischen dem Kühlkörper und dem zu kühlenden Substrat den Wärmeübergang zu verbessern. Das erfolgt bei bandförmigen Substraten in der Regel durch Erhöhen des Bandzuges. Dieser Methode sind jedoch ebenfalls physikalische Grenzen gesetzt, da auch bei starker Zunahme des Anpressdruckes die wirksame Kontaktfläche nur geringfügig vergrößert wird, was im Wesentlichen durch mikrogeometrische Gegebenheiten erklärt werden kann.

Es ist bekannt, durch Öffnungen, die durch Ventile geschlossen werden können, Gas unterhalb des zu kühlenden Substrates einzuleiten (US 3,414,048). Die Vielzahl von Ventilen erhöht allerdings die mechanische Anfälligkeit eines solchen Anlagensystems.

Es ist weiterhin bekannt, eine Gaszufuhr durch die Kühlfläche hindurch zu realisieren, indem ein Teil der Kühlfläche als poröser Formkörper ausgebildet wird (US 5,076,203). Nachteilig ist bei diesem Verfahren die große Menge des nach der Substratkühlung in den Rezipienten abströmenden Kühlgases, die das Prozessvakuum belastet.

Schließlich ist bekannt, Kühlgas unter einer Haube durch Löcher in den Ringspalt einer Kühltrommel einzulassen (WO 02/070778 A1). Dadurch kann ein bestimmter Gasdruck unter dem Substrat anliegen. Es wird weiterhin erwähnt, den Kontaktbereich zwischen Kühlwalze und Substrat seitlich abzudichten und weitere Einlassoptionen zu nutzen. Auch diese technische Ausführung weist jedoch keinen effektiven Weg, das einmal eingeleitete Kühlgas möglichst effektiv vom Prozessvakuum fernzuhalten, nachdem sich Kühlfläche und zu kühlendes Substrat nicht mehr in Kontakt befinden.

Zusammenfassend kann zum Stand der Technik angemerkt werden, dass der Schwerpunkt der Bemühungen zum Kühlen bandförmiger Substrate offensichtlich darauf gelegt wird, den Wärmekontakt zwischen Substrat und Kühlkörper durch einen verbleibenden Restspalt mit definierter Gasbefüllung zu vermitteln. Problematisch ist jedoch, dass der hierzu mindestens erforderliche Gasdruck bei bewegten bandförmigen Substraten eine ständige Zufuhr einer erheblichen Gasmenge erfordert, die zumindest teilweise das Prozessvakuum belastet, nachdem sie aus der Kühlzone entwichen ist. Für viele vakuumtechnische Anwendungen, z. B. alle Anwendungen, bei denen mit einem Elektronenstrahl gearbeitet wird, stellt das ein in vielerlei Hinsicht limitierendes Problem dar.

Der Erfindung liegt daher das technische Problem zugrunde eine Vorrichtung und ein Verfahren zu schaffen, die eine gegenüber dem Stand der Technik verbesserte Substratkühlung bewegter bandförmiger Substrate erlauben. Das Kühlverfahren soll vakuumtauglich sein und die vorgenannten Nachteile des Standes der Technik vermeiden.

Die Lösung des technischen Problems ergibt sich durch die Gegenstände mit den Merkmalen der Patentansprüche 1 und 13. Weitere vorteilhafte Ausgestaltungen der Erfindung ergeben sich aus den abhängigen Ansprüchen.

Die Erfindung geht davon aus, dass es zweckmäßig ist, zur Vermittlung des Wärmekontaktes zwischen einem zu kühlenden Substrat und einem Kühlkörper ein Fluid einzusetzen, welches mit der Rückseite des Substrates und der Oberfläche des Kühlkörpers in direktem Kontakt steht. Spaltgeometrie, Fluidart und Fluiddruck sind dabei die bestimmenden Parameter. Der Wärmeübergang vom Substrat zum Kühlkörper erfolgt umso effektiver, je kleiner der Abstand zwischen Substrat und Kühlkörper und je höher der Druck des den Wärmekontakt vermittelnden Fluids ist.

Ein hoher Fluiddruck bewirkt eine hohe mechanische Belastung des Substrates, da das Substrat eine Trennfläche zwischen Fluid und Vakuum bildet und aus der Druckdifferenz resultierende Kräfte aufnehmen muss. Die Aufnahme dieser Kräfte erfolgt durch eine elastische Dehnung des Substrates, wodurch den durch die Druckdifferenz bedingten Kräften entgegenwirkende Rückstellkräfte erzeugt werden.

Da außerdem hohe Fluiddrücke für eine effektive Kühlung angestrebt werden sollten, gleichzeitig aber möglichst wenig Fluid in das Prozessvakuum entweichen darf, ergeben sich weitere Anforderungen, die durch die erfindungsgemäße Lösung der Aufgabe erfüllt werden müssen.

Demgemäß werden in dem erfindungsgemäßen Verfahren die für.die Aufnahme von durch einen hohen Fluiddruck am Substrat anliegenden Kräften erforderlichen Rückstellkräfte durch eine hohe elastische Vorspannung des Substrates, das um eine konvexe Kühlfläche geführt wird, erzeugt. Die Vorspannung wird durch einen Bandzug derart eingestellt, dass die durch den Fluiddruck am Substrat anliegenden Kräfte kein Abheben des Substrates von der konvexen Kühlfläche bewirken. Indem das bandförmige, unter hohem Bandzug stehende Substrat um eine konvexe Kühlfläche geführt wird, ergibt sich ein bestimmter Anpressdruck, mit dem das Substrat gegen den von ihm umschlungenen Bereich der Kühlfläche gepresst wird. Auch bei sehr glatten Kühlflächen verbleibt eine Spaltgeometrie zwischen Substratrückseite und Kühlfläche, die für eine erfindungsgemäße Fluidbefüllung ausreicht. Vom Vorhandensein eines befüllbaren Spaltbereiches zwischen Substratrückseite und Kühlfläche kann basierend auf mikrogeometrischen Oberflächengegebenheiten grundsätzlich ausgegangen werden.

Zum Kühlen des Substrates erfolgt die Befüllung des Spaltes mit einem Fluid, welches einen guten Wärmekontakt zwischen Substrat und Kühlfläche vermittelt. Die durch den Fluiddruck auf das Substrat ausgeübten Kräfte wirken den durch den stärken Bandzug auf die Kühlfläche ausgeübten Kräften entgegen. Eine sichere Substratführung über die Kühlfläche bleibt jedoch bestehen, solange die durch den Fluiddruck auf das Substrat ausgeübten Kräfte dem Betrag nach kleiner sind als die den Anpressdruck verursachenden Kräfte, die im Wesentlichen durch Variieren des Bandzuges einstellbar sind.

Die Erfindung geht weiterhin davon aus, dass ein effektiver Umgang mit einem fluidgefüllten Spaltbereich zwischen Substrat und Kühlfläche ohne starke Belastung des Prozessvakuums nur erfolgen kann, wenn im Kontaktbereich zwischen Substrat und Kühlfläche sowohl die Fluidzufuhr als auch eine Fluidabfuhr erfolgt.

Die Erfindung wird realisiert durch eine Vorrichtung und ein Verfahren zum Kühlen bandförmiger Substrate im Vakuum, umfassend mindestens eine konvexe Kühlfläche als Begrenzung eines Kühlkörpers, Mittel zum Führen mindestens eines bandförmigen Substrates derart, dass das Substrat die konvexe Kühlfläche zumindest teilweise in einem Kontaktbereich umschlingt, wobei im Kontaktbereich ein Spalt zwischen Kühlfläche und Substrat ausgebildet wird; Mittel zum Zuführen eines Fluids in mindestens einen ersten Bereich des Spaltes und Mittel zum Abführen des Fluids aus mindestens einem zweiten Bereich des Spaltes, wobei die Mittel zum Zuführen des Fluids in den ersten Spaltbereich und die Mittel zum Abführen des Fluids aus dem zweiten Spaltbereich derart ausgebildet sind, dass das Zuführen des Fluids in den ersten Spaltbereich und das Abführen des Fluids aus dem zweiten Spaltbereich durch die Kühlfläche hindurch erfolgt.

Vorteilhafterweise wird dabei am Substrat ein Bandzug eingestellt, der an der konvexen Kühlfläche einen Anpressdruck erzeugt, der dem Betrag nach größer ist, als der Fluiddruck im ersten Spaltbereich zwischen Kühlfläche und Substratrückseite. Dadurch wird neben einer sicheren Führung des bandförmigen Substrates eine geringe Belastung des Prozessvakuums gewährleistet, da ein verstärktes Entweichen des Fluids in einen Rezipienten, wie es bei einem Abheben des Substrates von der Kühlfläche der Fall wäre, verhindert wird.

Es hat sich gezeigt, dass eine Dehnung des Substrates, die ausreichend hohe Anpressdrücke erzeugt, mit vielen Vakuumbeschichtungsschritten oder Oberflächenbehandlungen kombiniert werden kann, ohne dass die anschließende Entspannung des Substrates nach Aufgabe des Bandzuges die Qualität der Beschichtung oder das angestrebte technologische Ziel merklich beeinträchtigt. Besonders trifft das auf eine Anwendung des erfindungsgemäßen Verfahrens mit metallischen Substraten zu.

Eine Kühlung lässt sich bei diesen Substraten realisieren, wenn ein Fluiddruck im ersten Spaltbereich von mindestens 100 Pa eingestellt wird. Ein besonders effektiver Druckbereich, bei dem eine sehr effektive Kühlung erfolgt und die zum Erzeugen des erforderlichen Anpressdruckes erforderliche Dehnung noch in einem Bereich liegt, in dem eine später vorzunehmende Entspannung des Substrates keine nennenswerten Schäden verursacht, liegt oberhalb von 500 Pa.

Das erfindungsgemäße Verfahren kann sowohl mit flüssigen als auch gasförmigen Fluiden wie beispielsweise Wasserstoff oder Luft ausgeführt werden. Wird mit einem Gas als Fluid gearbeitet, so ist ein geringes Molekulargewicht besonders vorteilhaft.

Werden die vakuumtechnolgischen Prozesse zum Beschichten eines Substrates unter Beteiligung eines Reaktivgases und/oder eines Inertgases ausgeführt, kann es vorteilhaft sein, eine dieser gasförmigen Komponenten gleichzeitig als den Wärmekontakt zwischen Substrat und Kühlkörper vermittelndes Fluid einzusetzen. Die Anforderungen an die Abdichtung des Zwischenraumes zwischen Substrat und Kühlkörper, der zumindest gegenüber dem Vakuum des Prozessraumes unter Überdruck steht, sind dann wesentlich geringer. Geringe Mengen austretenden Fluids stellen dann auch keine Verunreinigungen im Prozessraum dar. Als fluidgeeignete Reaktivgase können beispielsweise Sauerstoff oder Stickstoff verwendet werden. Bei Inertgasen sind beispielsweise Helium und Argon als Fluid einsetzbar.

Bei einer Ausführungsform der Erfindung wird Stickstoff als Fluid verwendet. Der Stickstoff wird in flüssiger Form in den ersten Spaltbereich eingebracht und geht dort in den gasförmigen Zustand über. Im gasförmigen Zustand wird der Stickstoff auch wieder aus dem zweiten Spaltbereich abgepumpt. Beim Übergang vom flüssigen in den gasförmigen Zustand wird der Umgebung Energie entzogen und somit eine verstärkte kühlende Wirkung erzielt.
Eine weitere Steigerung der Effektivität des erfindungsgemäßen Verfahrens lässt sich realisieren, wenn während des Kühlvorganges das Fluid den ersten und zweiten Spaltbereich zwischen Kühlfläche und Substratrückseite zumindest teilweise und/oder zeitweise durchströmt. Auf diese Weise wird zusätzlich zur Vermittlung eines guten Wärmekontaktes zwischen Substrat und Kühlfläche die Wärmekapazität des abströmenden Fluids für die Substratkühlung genutzt.

Erfindungsgemäße Vorrichtungen zum rückseitigen Kühlen bandförmiger Substrate im Vakuum umfassen mindestens eine konvexe Kühlfläche als Begrenzung eines Kühlkörpers, Mittel zum Führen mindestens eines bandförmigen Substrates derart, dass das Substrat die konvexe Kühlfläche zumindest teilweise umschlingt, Mittel zum Zuführen eines Fluids in mindestens einen ersten Spaltbereich zwischen Kühlfläche und Substratrückseite und Mittel zum Abführen des Fluids aus mindestens einem zweiten Spaltbereich zwischen Kühlfläche und Substratrückseite, wobei die Mittel zum Zuführen und Abführen des Fluids derart ausgeführt sind, dass das Zuführen und Abführen des Fluids im Wesentlichen in einem Kontaktbereich zwischen Substratrückseite und Kühlfläche durch die Kühlfläche hindurch erfolgt.

Vorteilhafterweise umfassen die Mittel zum Führen des bandförmigen Substrates ein Bandlaufwerk, das es ermöglicht, am Substrat einen Bandzug einzustellen, der an der konvexen Kühlfläche einen Anpressdruck erzeugt, der dem Betrag nach größer ist, als der Fluiddruck im ersten Spaltbereich zwischen Kühlfläche und Substratrückseite. Dadurch kann es zu keinem Zeitpunkt zu einem Abheben des Substrates von der Kühlfläche kommen.

Zweckmäßigerweise umfassen die Mittel zum Zuführen des Fluids in den ersten Spaltbereich zwischen Kühlfläche und Substratrückseite Bohrungen durch die Kühlfläche, durch die der erste Spaltbereich mit mindestens einem Fluidreservoir in Verbindung steht, in dem ein Fluiddruck herrscht, der über dem Arbeitsdruck im Prozessvakuum liegt. Aus diesem Reservoir erfolgt das Zuführen eines Fluids in den ersten Spaltbereich zwischen Kühlfläche und Substratrückseite durch die Kühlfläche hindurch. Bei sehr straffem Anliegen des Substrates am Kühlkörper lassen sich allein durch den Strömungswiderstand, den der enge Spalt einem einströmenden Fluid entgegensetzt, bei mäßiger Belastung des Vakuums Fluiddrücke realisieren, die für eine erfindungsgemäße Kühlung geeignet sind. Besonders vorteilhafte Ausführungsformen umfassen jedoch Dichtmittel, die den Spaltbereich zwischen Kühlfläche und Substratrückseite parallel zur Bandlaufrichtung zum Prozessvakuum hin abdichten. Dadurch kommt es auch bei vergleichsweise hohen Fluiddrücken zu keiner größeren Belastung des Prozessvakuums. Die ausgewählten Dichtmittel hängen jeweils von den ausgewählten Druckbereichen, dem Saugvermögen des Vakuumsystems und möglicherweise weiteren technologischen Randbedingungen ab.

Vorteilhaft ist es, wenn die Mittel zum Abführen des Fluids aus dem zweiten Spaltbereich zwischen Kühlfläche und Substratrückseite Bohrungen durch die Kühlfläche umfassen, durch die der Spaltbereich zwischen Substratrückseite und Kühlfläche mit mindestens einem abpumpbaren Volumen in Verbindung steht.

Besonders vorteilhaft ist es, wenn mindestens ein Fluidreservoir und mindestens ein abpumpbares Volumen so angeordnet sind, dass durch die Bohrungen in der Kühlfläche der fluidgefüllte Bereich des Spaltbereiches zwischen Kühlfläche und Substratrückseite in Bandlaufrichtung beidseitig durch Bereiche begrenzt wird, in denen ein Abpumpen des Fluids erfolgt. In diesem Fall läuft das bandförmige Substrat, nachdem es mit der konvexen Kühlfläche in Kontakt gebracht wurde, zunächst über einen Bereich der Kühlfläche, durch den hindurch ein Abpumpen evtl. abströmender Fluidanteile erfolgt. Anschließend wird das Substrat über einen Bereich der Kühlfläche geführt, über dem sich zwischen Substrat und Kühlfläche ein Fluiddruck einstellt, der durch die Bohrungen in der Kühlfläche aus dem Fluidreservoir gespeist wird. Bevor das Substrat den Kontaktbereich mit der Kühlfläche verlässt, läuft das Substrat nochmals über einen Bereich der Kühlfläche, durch den hindurch ein Abpumpen abströmender Fluidanteile erfolgt. Im Zusammenwirken mit einer seitlichen. Abdichtung des fluidgefüllten Spaltbereiches lässt sich auf diese Weise eine sehr effektive Kühlung nahezu ohne Belastung des Vakuums im Rezipienten realisieren. Besonders vorteilhaft ist es, wenn mindestens ein Fluidreservoir und mehrere abpumpbare Volumina so angeordnet sind, dass durch die Bohrungen in der Kühlfläche der fluidgefüllte Bereich des Spaltbereiches zwischen Kühlfläche und Substratrückseite in Bandlaufrichtung beidseitig durch Bereiche begrenzt wird, in denen durch Abpumpen des Fluids ein mehrstufiges Reduzieren des Fluiddruckes erfolgen kann. Dadurch erreicht man eine sehr effektive mehrstufige Druckentkopplung zwischen dem Fluidreservoir und dem Vakuum im Rezipienten.

Soll die Kühlung durch eine Fluidströmung intensiviert werden, so kann das auf einfache Weise durch Erhöhung der eingeleiteten Fluidmenge und intensiveres Abpumpen des Fluids aus dem Spaltbereich zwischen Kühlfläche und Substratrückseite bewirkt werden. Auch in diesem Fall ist eine mehrstufige Druckentkopplung besonders vorteilhaft.

Eine besonders einfache Ausführungsform ergibt sich, wenn der durch die Kühlfläche begrenzte Kühlkörper so ausgeführt ist, dass er sich bei einer vorgesehenen thermischen Belastung durch eine ausreichend hohe Wärmekapazität nur langsam erwärmt. Es kann jedoch auch vorteilhaft sein, den durch die Kühlfläche begrenzten Kühlkörper so auszugestalten, dass er selbst durch ein ihn durchströmendes Kühlmedium gekühlt werden kann.

Mit Vorteil kann die Kühlfläche derart profiliert ausgeführt werden, dass sich zwischen Substratrückseite und Kühlfläche fluidgefüllte Zwischenräume mit unterschiedlichen Abständen zwischen Substratrückseite und Kühlfläche ausbilden. Auf diese Weise lässt sich eine Fluidströmung besonders wirkungsvoll einsetzen.

Typische Ausgestaltungen der in erfindungsgemäßen Vorrichtungen verwendeten Kühlflächen stellen Mantelflächen von Kühlwalzen dar. In einer alternativen Ausgestaltung ist der substratumschlungene Bereich der Kühlfläche Teil einer feststehenden Formschulter. In diesem Fall kann es vorteilhaft sein, die Verbindung zu einem Fluidreservoir und abpumpbaren Volumina über in die Kühlfläche integrierte poröse Formstücke zu gewährleisten.

Die vorliegende Erfindung wird nachfolgend anhand eines bevorzugten Ausführungsbeispiels näher erläutert. Die Figuren zeigen:
- Fig. 1: eine schematische Schnittdarstellung einer Vorrichtung zum Durchführen des erfindungsgemäßen Verfahrens mit Schnittebene parallel zur Bandlaufrichtung,
- Fig. 2: eine schematische Schnittdarstellung der Vorrichtung gemäß Fig. 1 mit Schnittebene quer zur Bandlaufrichtung.

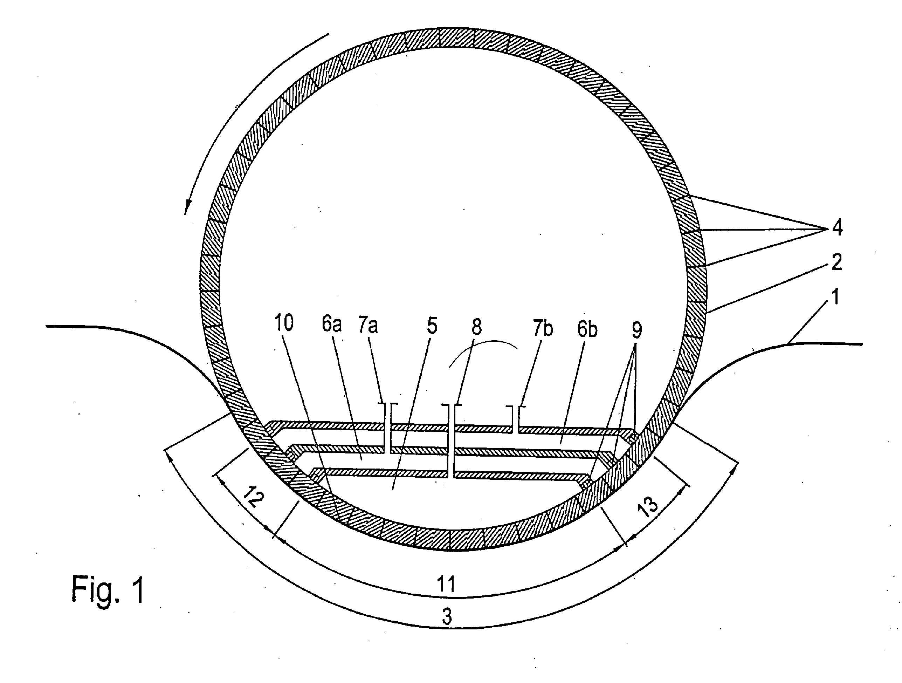

In Fig. 1 schematisch dargestellt ist ein zu kühlendes bandförmiges Substrat 1, welches auf einer Seite mittels eines Vakuumverfahrens innerhalb einer nicht dargestellten Prozesskammer beschichtet werden soll. Dazu wird das Substrat 1 über eine drehbare Kühlwalze 2 geführt und liegt in einem Kontaktbereich 3 mit der nicht zu beschichtenden Seite flächig an Kühlwalze 2 an. Die Kühlwalze 2 weist zahlreiche Bohrungen 4 auf, die durch die Mantelfläche der Kühlwalze 2 führen. Im Inneren der Kühlwalze 2 befindet sich ein Fluidreservoir 5, in dem ein erhöhter Druck gegenüber dem Vakuum auf der zu beschichtenden Seite des Substrates 1 innerhalb der Prozesskammer herrscht. Das Fluidreservoir 5 umgeben zwei abpumpbare Kammern 6a, 6b, die über Pumpstutzen 7a, 7b evakuiert werden können, wobei Fluidreservoir 5 über einen Stutzen 8 befüllbar ist. Die unbeweglichen Kammerwände der Volumenbereiche 5, 6a, 6b stehen über Schleifdichtungen 9 mit der Innenseite der Kühlwalze 2 in Kontakt.

Obwohl das Substrat 1 im Kontaktbereich 3 flächig an Kühlwalze 2 gepresst wird, entsteht in diesem Bereich zwischen Substrat 1 und Kühlwalze 2 aufgrund mikrogeometrischer Gegebenheiten ein im Erfindungssinn hinreichender Spalt 10 mit gleich bleibender Spaltgeometrie.

Durch die Ausgestaltung der Kühlwalze 2 mit zahlreichen Bohrungen 4, liegt im Spalt 10 in einem Bereich 11 ein Fluiddruck an, der im Wesentlichen durch den Druck im Fluidreservoir 5 bestimmt wird. Seitlich von diesem Bereich 11 erfolgt einlauf- und auslaufseitig in Bereichen 12 bzw. 13 ein mehrstufiger Druckabbau durch Evakuieren der abpumpbaren Kammern 6a, 6b. In den Bereichen 12 und 13 des Spaltes 10 wird also das Fluid, das im Bereich 11 in den Spalt 10 gepresst wird, wieder aus dem Spalt 10 abgesaugt. Durch den Einsatz der Schleifdichtungen 9 kann dieser Druckverlauf im Spalt 10 auch hinter bewegten Substraten aufrechterhalten werden. Ein Entweichen des Fluids in Längsrichtung des Substrates 1 in den Vakuumbereich der Prozesskammer wird somit stark reduziert bzw. vollständig verhindert.

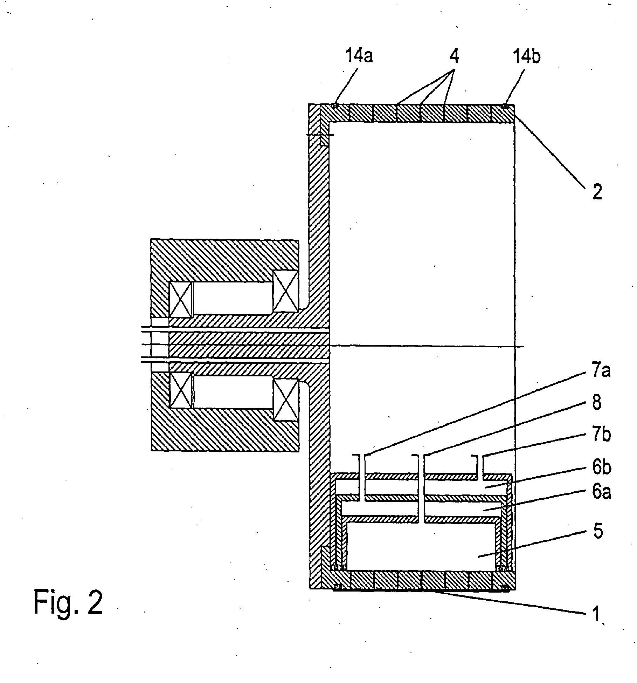

Fig. 2 zeigt die in Fig. 1 beschriebene erfindungsgemäße Vorrichtung als schematische Schnittdarstellung quer zur Laufrichtung des Substrates 1. Die einseitig offene Form der Kühlwalze 2 erlaubt eine besonders einfache Adaption verschiedener Fluid- und Evakuierungssysteme, um eine Anpassung an verschiedene vakuumtechnische Prozesse vorzunehmen. Die Kühlwalze 2 ist zum seitlichen Abdichten des Spaltes 10 zwischen Substratrückseite und Kühlfläche mit umlaufenden Dichtungen 14a; 14b ausgestattet.

Somit wird der unter hohem Fluiddruck stehende Bereich 11 des Spaltes 10 auf zwei gegenüberliegenden Seiten durch die Dichtungen 14a und 14b und auf den anderen beiden gegenüberliegenden Seiten durch die evakuierbaren Bereiche 12 und 13 begrenzt, wodurch das Entweichen des Fluids in die Prozesskammer verhindert wird. Dadurch wird einerseits die Prozesskammer nicht mit Fluidbestandteilen verunreinigt und andererseits ergibt sich ein ökonomischer Vorteil, weil das aus den Bereichen 12 und 13 evakuierte Fluid erneut verwendet werden kann.

Anstelle von Dichtungen 14a; 14b oder auch in Kombination mit diesen Dichtungen ist es auch möglich das Fluid aus den Bereichen des Spaltes 10 an den Seitenrändern des Substrates 1 stufenweise durch die Kühlwalze 2 hindurch abzupumpen, um somit ein Entweichen des Fluids in das Prozessvakuum zu verhindern.

## Patentansprüche

1. Vorrichtung zum Kühlen bandförmiger Substrate im Vakuum umfassend mindestens eine konvexe Kühlfläche als Begrenzung eines Kühlkörpers (2), Mittel zum Führen mindestens eines bandförmigen Substrates (1) derart, dass das Substrat (1) die konvexe Kühlfläche zumindest teilweise in einem Kontaktbereich (3) umschlingt, wobei im Kontaktbereich (3) ein Spalt (10) zwischen Kühlfläche und Substrat (1) ausbildbar ist;
Mittel (8) zum Zuführen eines Fluids in mindestens einen ersten Bereich (11) des Spaltes (10) und
Mittel (7a; 7b) zum Abführen des Fluids aus mindestens einem zweiten Bereich (12; 13) des Spaltes (10), **dadurch gekennzeichnet, dass** die Mittel (8) zum Zuführen des Fluids in den Spaltbereich (11) und die Mittel (7a; 7b) zum Abführen des Fluids aus dem Spaltbereich (12; 13) derart ausgebildet sind, dass das Zuführen des Fluids in den Spaltbereich (11) und das Abführen des Fluids aus dem Spaltbereich (12; 13) durch die Kühlfläche hindurch erfolgt.

2. Vorrichtung nach Anspruch 1, **dadurch gekennzeichnet, dass** die Mittel zum Führen des bandförmigen Substrates ein Bandlaufwerk umfassen, mittels dem am Substrat ein Bandzug einstellbar ist, der an der konvexen Kühlfläche einen Anpressdruck erzeugt, der dem Betrag nach größer ist, als der Fluiddruck im ersten Spaltbereich (11) zwischen Kühlfläche und Substrat (1).

3. Vorrichtung nach Anspruch 1 oder 2, **dadurch gekennzeichnet, dass** die Mittel zum Zuführen des Fluids in den ersten Spaltbereich zwischen Kühlfläche und Substratrückseite Bohrungen (4) durch die Kühlfläche umfassen, durch die der erste Spaltbereich (11) zwischen Substrat (1) und Kühlfläche mit mindestens einem Fluidreservoir (5) in Verbindung steht, in dem ein Fluiddruck herrscht, der über dem Arbeitsdruck im Prozessvakuum liegt.

4. Vorrichtung nach einem der vorhergehenden Ansprüche, **dadurch gekennzeichnet, dass** die Mittel zum Abführen des Fluids aus dem zweiten Spaltbereich (12; 13) zwischen Kühlfläche und Substrat Bohrungen (4) durch die Kühlfläche umfassen, durch die der zweite Spaltbereich (12; 13) zwischen Substratrückseite und Kühlfläche mit mindestens einem abpumpbaren Volumen (6a; 6b) in Verbindung steht.

5. Vorrichtung nach einem der vorhergehenden Ansprüche, **dadurch gekennzeichnet, dass** an den ersten Spaltbereich (11) in Bandlaufrichtung beidseitig ein zweiter Spaltbereich (12; 13) angrenzt.

6. Vorrichtung nach einem der vorhergehenden Ansprüche, **dadurch gekennzeichnet, dass** die Mittel zum Abführen des Fluids aus dem zweiten Spaltbereich derart ausgebildet sind, dass der Fluiddruck im zweiten Spaltbereich mehrstufig reduzierbar ist.

7. Vorrichtung nach einem der vorhergehenden Ansprüche, **dadurch gekennzeichnet, dass** Dichtmittel (14a; 14b) vorhanden sind, die den ersten Spaltbereich (11) oder/und zweiten Spaltbereich (12; 13) zum Prozessvakuum hin abdichten.

8. Vorrichtung nach einem der vorhergehenden Ansprüche, **dadurch gekennzeichnet, dass** der durch die konvexe Kühlfläche begrenzte Kühlkörper derart ausgebildet ist, dass dieser bei einer thermischen Belastung durch eine ausreichend hohe Wärmekapazität nur langsam erwärmbar ist.

9. Vorrichtung nach einem der vorhergehenden Ansprüche, **dadurch gekennzeichnet, dass** der durch die Kühlfläche begrenzte Kühlkörper selbst mittels eines Kühlmediums kühlbar ist.

10. Vorrichtung nach einem der vorhergehenden Ansprüche, **dadurch gekennzeichnet, dass** die Kühlfläche derart profiliert ausgeführt ist, dass sich zwischen Substrat und Kühlfläche fluidgefüllte Zwischenräume mit unterschiedlichen Abständen zwischen Substrat und Kühlfläche ausbilden.

11. Vorrichtung nach einem der vorhergehenden Ansprüche, **dadurch gekennzeichnet, dass** der substratumschlungene Bereich der Kühlfläche Teil der Mantelfläche einer Kühlwalze ist.

12. Vorrichtung nach einem der vorhergehenden Ansprüche, **dadurch gekennzeichnet, dass** der substratumschlungene Bereich der Kühlfläche Teil einer feststehenden Formschulter ist.

13. Verfahren zum Kühlen bandförmiger Substrate im Vakuum, wobei ein Substrat (1) derart geführt wird, dass es eine konvexe Kühlfläche zumindest teilweise in einem Kontaktbereich (3) umschlingt und im Kontaktbereich (3) ein Spalt (10) zwischen Substrat (1) und Kühlfläche ausgebildet wird, **dadurch gekennzeichnet, dass** in mindestens einem ersten Bereich (11) des Spaltes (10) ein Fluid durch die Kühlfläche hindurch zugeführt und dieses Fluid zumindest teilweise aus mindestens einem zweiten Bereich (12; 13) des Spaltes (10) durch die Kühlfläche hindurch abgeführt wird.

14. Verfahren nach Anspruch 13, **dadurch gekennzeichnet, dass** am Substrat (1) ein Bandzug eingestellt wird, der an der konvexen Kühlfläche einen Anpressdruck erzeugt, der dem Betrag nach größer ist, als der Fluiddruck im ersten Spaltbereich zwischen Kühlfläche und Substratrückseite.

15. Verfahren nach Anspruch 13 oder 14, **dadurch gekennzeichnet, dass** im ersten Spaltbereich (11) ein Fluiddruck von mindestens 100 Pa eingestellt wird.

16. Verfahren nach Anspruch 15, **dadurch gekennzeichnet, dass** im ersten Spaltbereich (11) ein Fluiddruck von mindestens 500 Pa eingestellt wird.

17. Verfahren nach einem der Ansprüche 13 bis 16, **dadurch gekennzeichnet, dass** eine Flüssigkeit als Fluid verwendet wird.

18. Verfahren nach einem der Ansprüche 13 bis 16, **dadurch gekennzeichnet, dass** ein Gas oder Gasgemisch als Fluid verwendet wird.

19. Verfahren nach Anspruch 18, **dadurch gekennzeichnet, dass** ein Reaktivgas als Fluid verwendet wird.

20. Verfahren nach Anspruch 19, **dadurch gekennzeichnet, dass** Sauerstoff oder Stickstoff als Fluid verwendet wird.

21. Verfahren nach Anspruch 18, **dadurch gekennzeichnet, dass** ein Inertgas als Fluid verwendet wird.

22. Verfahren nach Anspruch 21, **dadurch gekennzeichnet, dass** Helium oder Argon als Fluid verwendet wird.

23. Verfahren nach Anspruch 18, **dadurch gekennzeichnet, dass** Wasserstoff als Fluid verwendet wird.

24. Verfahren nach Anspruch 18, **dadurch gekennzeichnet, dass** Luft als Fluid verwendet wird.

25. Verfahren nach einem der Ansprüche 13 bis 24, **dadurch gekennzeichnet, dass** während des Kühlvorganges das Fluid den ersten Spaltbereich (11) und den zweiten Spaltbereich (12; 13) zumindest teilweise und/oder zeitweise durchströmt.

## Claims

1. Device for cooling strip substrates in a vacuum, comprising at least one convex cooling surface as delimitation of a cooling body (2), means for guiding at least one strip substrate (1) in such a manner that the substrate (1) encircles the convex cooling surface at least partially in a contact region (3), a gap (10) being able to be configured in the contact region (3) between cooling surface and substrate (1);
means (8) for supplying a fluid into at least one first region (11) of the gap (10) and
means (7a; 7b) for discharging the fluid from at least one second region (12; 13) of the gap (10), **characterised in that** the means (8) for supplying the fluid into the gap region (11) and the means (7a; 7b) for discharging the fluid from the gap region (12; 13) are configured in such a manner that the supply of fluid into the gap region (11) and the discharge of the fluid from the gap region (12; 13) is effected through the cooling surface.

2. Device according to claim 1, **characterised in that** the means for guiding the strip substrate comprise a strip drive, by means of which a strip tension on the substrate is adjustable, said strip tension producing a contact pressure on the convex cooling surface which is greater according to quantity than the fluid pressure in the first gap region (11) between cooling surface and substrate (1).

3. Device according to claim 1 or 2, **characterised in that** the means for supplying the fluid into the first gap region between cooling surface and substrate rear-side comprise borings (4) through the cooling surface, by means of which the first gap region (11) between substrate (1) and cooling surface is in communication with at least one fluid reservoir (5) in which a fluid pressure prevails which is above the operating pressure in the process vacuum.

4. Device according to one of the preceding claims, **characterised in that** the means for discharging the fluid from the second gap region (12; 13) between cooling surface and substrate comprise borings (4) through the cooling surface, by means of which the second gap region (12; 13) between substrate rear-side and cooling surface is in communication with at least one volume (6a; 6b) which can be pumped away.

5. Device according to one of the preceding claims, **characterised in that** a second gap region (12; 13) abuts against the first gap region (11) on both sides in the strip running direction.

6. Device according to one of the preceding claims, **characterised in that** the means for discharging the fluid from the second gap region are configured in such a manner that the fluid pressure in the second gap region can be reduced in several stages.

7. Device according to one of the preceding claims, **characterised in that** sealing means (14a; 14b) are present which seal the first gap region (11) or/and second gap region (12; 13) towards the process vacuum.

8. Device according to one of the preceding claims, **characterised in that** the cooling body delimited by the convex cooling surface is configured in such a manner that the latter can be heated only slowly during thermal loading by a sufficiently high heat capacity.

9. Device according to one of the preceding claims, **characterised in that** the cooling body delimited by the cooling surface can itself be cooled by means of a coolant.

10. Device according to one of the preceding claims, **characterised in that** the cooling surface is configured in a profiled manner such that fluid-filled intermediate spaces between substrate and cooling surface are configured at different spacings between substrate and cooling surface.

11. Device according to one of the preceding claims, **characterised in that** the substrate-encircled region of the cooling surface is part of the outer peripheral surface of a cooling roller.

12. Device according to one of the preceding claims, **characterised in that** the substrate-encircled region of the cooling surface is part of a stationary shaped shoulder.

13. Method for cooling strip substrates in a vacuum, a substrate (1) being guided in such a manner that it encircles a convex cooling surface at least partially in one contact region (3) and a gap (10) is configured in the contact region (3) between substrate (1) and cooling surface, **characterised in that** a fluid is supplied in at least one first region (11) of the gap (10) through the cooling surface and this fluid is discharged at least partially from at least one second region (12; 13) of the gap (10) through the cooling surface.

14. Method according to claim 13, **characterised in that** a strip tension is adjusted on the substrate (1), said strip tension producing a contact pressure on the convex cooling surface which is greater according to quantity than the fluid pressure in the first gap region between cooling surface and substrate rear-side.

15. Method according to claim 13 or 14, **characterised in that** a fluid pressure of at least 100 Pa is adjusted in the first gap region (11).

16. Method according to claim 15, **characterised in that** a fluid pressure of at least 500 Pa is adjusted in the first gap region (11).

17. Method according to one of the claims 13 to 16, **characterised in that** a liquid is used as fluid.

18. Method according to one of the claims 13 to 16, **characterised in that** a gas or gas mixture is used as fluid.

19. Method according to claim 18, **characterised in that** a reactive gas is used as fluid.

20. Method according to claim 19, **characterised in that** oxygen or nitrogen is used as fluid.

21. Method according to claim 18, **characterised in that** an inert gas is used as fluid.

22. Method according to claim 21, **characterised in that** helium or argon is used as fluid.

23. Method according to claim 18, **characterised in that** hydrogen is used as fluid.

24. Method according to claim 18, **characterised in that** air is used as fluid.

25. Method according to one of the claims 13 to 24, **characterised in that** the fluid flows through the first gap region (11) and the second gap region (12; 13) during the cooling process at least partially and/or temporarily.

## Revendications

1. Dispositif pour refroidir sous vide des substrats en forme de bande comprenant au moins une surface de refroidissement, convexe, comme limite d'un organe de refroidissement (2),
- des moyens pour guider au moins un substrat (1) en forme de bande de façon que le substrat (1) enveloppe au moins partiellement la surface de refroidissement convexe dans la zone de contact (3), un intervalle (10) existant dans la zone de contact (3) entre la surface de refroidissement et le substrat (1),
- des moyens (8) pour fournir du fluide au moins dans une première zone (11) de l'intervalle (10) et
- des moyens (7a; 7b) pour évacuer le fluide à partir d'au moins une seconde zone (12; 13) de l'intervalle (10),
**caractérisé en ce que**
les moyens (8) pour fournir le fluide dans la zone d'intervalle (11) et les moyens (7a ; 7b) pour évacuer le fluide de la zone d'intervalle (12, 13) sont réalisés de façon que l'alimentation en fluide dans la zone d'intervalle (11) et l'évacuation du fluide de la zone d'intervalle (12, 13) se fassent à travers la surface de refroidissement.

2. Dispositif selon la revendication 1,
**caractérisé en ce que**
les moyens pour guider le substrat en forme de bande comprennent un mécanisme de circulation de bande qui règle la traction de bande au niveau du substrat générant une pression contre la surface de refroidissement convexe dont l'amplitude est supérieure à la pression du fluide dans la première zone d'intervalle (11) entre la surface de refroidissement et le substrat (1).

3. Dispositif selon la revendication 1 ou 2,
**caractérisé en ce que**
les moyens pour fournir le fluide dans la première zone d'intervalle entre la surface de refroidissement et le côté arrière du substrat comprennent des perçages (4) traversant la surface de refroidissement, à travers lesquels la première zone d'intervalle (11) entre le substrat (1) et la surface de refroidissement communique avec au moins un réservoir de fluide (5) dans lequel règne une pression de fluide supérieure à la pression de travail dans le vide de procédé.

4. Dispositif selon l'une des revendications précédentes,
**caractérisé en ce que**
les moyens pour évacuer le fluide de la seconde zone d'intervalle (12, 13) entre la surface de refroidissement et le substrat comprennent des perçages (4) traversant la surface de refroidissement et par lesquels la seconde zone d'intervalle (12, 13) entre le côté arrière du substrat et la surface de refroidissement communique au moins avec un volume (6a ; 6b) qui peut être pompé.

5. Dispositif selon l'une des revendications précédentes,
**caractérisé en ce qu'**
une seconde zone d'intervalle (12, 13) est adjacente des deux côtés à la première zone d'intervalle (11) dans la direction de circulation de la bande.

6. Dispositif selon l'une des revendications précédentes,
**caractérisé en ce que**
les moyens pour évacuer le fluide de la seconde zone d'intervalle sont réalisés pour réduire la pression du fluide dans la seconde zone d'intervalle en plusieurs étapes.

7. Dispositif selon l'une des revendications précédentes,
**caractérisé par**
des moyens d'étanchéité (14a ; 14b) qui assurent l'étanchéité de la première zone d'intervalle (11) et/ou de la seconde zone d'intervalle (12 ; 13) par rapport au vide de procédé.

8. Dispositif selon l'une des revendications précédentes,
**caractérisé en ce que**
l'organe de refroidissement délimité par la surface de refroidissement convexe est réalisé de façon que sous l'effet d'une sollicitation thermique il ne se réchauffe que lentement par une capacité calorifique suffisamment élevée.

9. Dispositif selon l'une des revendications précédentes,
**caractérisé en ce que**
l'organe de refroidissement délimité par la surface de refroidissement est lui-même refroidi par un fluide de refroidissement.

10. Dispositif selon l'une des revendications précédentes,
**caractérisé en ce que**
la surface de refroidissement est profilée de façon que se développent des espaces intermédiaires remplis de fluide entre le substrat et la surface de refroidissement et ayant des écarts différents entre le substrat et la surface de refroidissement.

11. Dispositif selon l'une quelconque des revendications précédentes,
**caractérisé en ce que**
la zone de la surface de refroidissement entourée par le substrat fait partie de la surface-enveloppe d'un cylindre de refroidissement.

12. Dispositif selon l'une des revendications précédentes,
**caractérisé en ce que**
la zone de la surface de refroidissement enveloppée par le substrat fait partie d'un épaulement de forme fixe.

13. Procédé de refroidissement sous vide de substrats en forme de bande, le substrat (1) étant guidé de façon à envelopper une surface de refroidissement au moins en partie convexe dans la zone de contact (3) et former un intervalle (10) dans la zone de contact (3) entre le substrat (1) et la surface de refroidissement,
**caractérisé en ce que**
dans au moins une première zone (11) de l'intervalle (10), le fluide passe à travers la surface de refroidissement et ce fluide est évacué au moins en partie de la seconde zone (12, 13) de l'intervalle (10) à travers la surface de refroidissement.

14. Procédé selon la revendication 13,
**caractérisé par**
un moyen de traction de bande réglé sur le substrat (1) pour exercer une pression contre la surface de refroidissement convexe, dont l'amplitude est supérieure à la pression du fluide dans la première plage d'intervalle entre la surface de refroidissement et le côté arrière du substrat.

15. Procédé selon la revendication 13 ou 14,
**caractérisé en ce qu'**
une pression de fluide d'au moins 100 Pa est réglée dans la première zone d'intervalle (11).

16. Procédé selon la revendication 15,
**caractérisé en ce qu'**
une pression de fluide d'au moins 500 Pa est réglée dans la première zone d'intervalle (11).

17. Procédé selon l'une des revendications 13 à 16,
**caractérisé en ce qu'**
on utilise un liquide comme fluide.

18. Procédé selon l'une des revendications 13 à 16,
**caractérisé en ce qu'**
on utilise un gaz ou un mélange gazeux comme fluide.

19. Procédé selon la revendication 18,
**caractérisé en ce qu'**
on utilise un gaz réactif comme fluide.

20. Procédé selon la revendication 19,
**caractérisé en ce qu'**
on utilise de l'oxygène ou de l'azote comme fluide.

21. Procédé selon la revendication 18,
**caractérisé en ce qu'**
on utilise un gaz inerte comme fluide.

22. Procédé selon la revendication 21,
**caractérisé en ce qu'**
on utilise de l'hélium ou de l'argon comme fluide.

23. Procédé selon la revendication 18,
**caractérisé en ce qu'**
on utilise de l'hydrogène comme fluide.

24. Procédé selon la revendication 18,
**caractérisé en ce qu'**
on utilise de l'air comme fluide.

25. Procédé selon l'une des revendications 13 à 24,
**caractérisé en ce que**
pendant l'opération de refroidissement le fluide traverse la première zone d'intervalle (11) et la seconde zone d'intervalle (12, 13) au moins en partie et/ou au moins de temps en temps.
